# EUROPÄISCHE PATENTANMELDUNG

(11) **EP 1 848 261 A1**
(43) Veröffentlichungstag der Anmeldung: **24.10.2007**
(21) Anmeldenummer: 07101905.3
(22) Anmeldetag: 07.02.2007
(51) Int. Cl.: H05K 13/02

(54) **Zuführvorrichtung für in einem Bauteilgurt gelagerte elektrische Bauteile**

(30) Priorität: 18.04.2006 DE 102006017842
(71) Anmelder: SIEMENS AKTIENGESELLSCHAFT, 80333 München (DE)
(72) Erfinder: Liebeke, Thomas, 85521 Ottobrunn (DE)

(57) **Zusammenfassung**

Eine Zuführvorrichtung (1) für in einem Bauteilgurt (2) gelagerte elektrische Bauteile (5)umfasst einen ersten Fördermechanismus (11), mittels dem der Bauteilgurt (2) in einer ersten Förderrichtung zu einer ersten Entnahmeposition (9) transportierbar ist, an der die Bauteile (5) dem Bauteilgurt (2) entnehmbar sind, eine Ablöseeinrichtung (12), mittels der eine Abdeckfolie (6) vom Bauteilgurt (2) ablösbar ist, einen zweiten Fördermechanismus (14), mittels dem die abgelöste Abdeckfolie (6) in einer zweiten Förderrichtung transportierbar ist, und einen Drehantrieb (17), welcher eine Antriebswelle (19) mit zwei freien Enden aufweist, wobei das erste freie Ende mit dem ersten Fördermechanismus (11) gekoppelt ist und das zweite freie Ende mit dem zweiten Fördermechanismus (14) gekoppelt ist.

## Beschreibung

Die Erfindung betrifft eine Zuführvorrichtung für elektrische Bauteile, welche in einem Bauteilgurt gelagert sind.

Aus der Offenlegungsschrift DE-19932021-A1 ist eine Zuführvorrichtung für in einem Bauteilgurt gelagerte elektrische Bauteile offenbart. Der Bauteilgurt weist eine ablösbare Abdeckfolie zum Schutz der Bauteile auf. Die Zuführvorrichtung umfasst zwei Fördermechanismen zum Transport des Bauteilgurts und der abgelösten Abdeckfolie. Zum Antrieb der Fördermechanismen dient ein Elektromotor mit einer Antriebswelle, an deren freiem Ende beide Fördermechanismen angekoppelt sind. Diese Konstruktion weist den Nachteil auf, dass aufgrund der unterschiedlichen Drehrichtungen und Drehgeschwindigkeiten der beiden Fördermechanismen sowie deren örtlicher Entfernung innerhalb der Zuführvorrichtung ein kompliziertes Kraftübertragungssystem, bestehend aus Zahnrädern und Riemen, vorzusehen ist.

Es ist deswegen die Aufgabe der vorliegenden Erfindung, eine Zuführvorrichtung mit einem einfachen Aufbau zu liefern.

Diese Aufgabe wird durch die Zuführvorrichtung gemäß dem unabhängigen Anspruch 1 gelöst. Vorteilhafte Ausgestaltungen sind Gegenstand der abhängigen Ansprüche.

Eine Zuführvorrichtung gemäß Anspruch 1 eignet sich zum Transport von in einem Bauteilgurt gelagerten elektrischen Bauteilen, wobei die Bauteile in taschenartigen Vertiefungen eines Grundkörpers des Bauteilgurts gelagert und mit einer lösbaren Abdeckfolie abgedeckt sind. Die Zuführvorrichtung weist einen ersten Fördermechanismus auf, mittels dem der Bauteilgurt in einer ersten Förderrichtung zu einer ersten Entnahmeposition transportierbar ist, an der die Bauteile dem Bauteilgurt entnehmbar sind. Die Zuführvorrichtung weist ferner eine erste Ablösevorrichtung auf, mittels der die Abdeckfolie vor der ersten Entnahmeposition vom Grundkörper des Bauteilgurts ablösbar ist. Ein zweiter Fördermechanismus ist vorgesehen, um die abgelöste Abdeckfolie in einer zweiten Förderrichtung zu transportieren. Die Zuführvorrichtung umfasst ferner einen Drehantrieb, welcher eine Antriebswelle mit zwei freien Enden aufweist, wobei das erste freie Ende mit dem ersten Fördermechanismus gekoppelt ist und das zweite freie Ende mit dem zweiten Fördermechanismus gekoppelt ist. Bei dieser Zuführvorrichtung sind der erste Fördermechanismus und der zweite Fördermechanismus im Bereich der zwei freien Enden der Antriebswelle mit dem Drehantrieb gekoppelt. Die Kraftübertragung des Drehantriebs auf den ersten Fördermechanismus und den zweiten Fördermechanismus findet daher an örtlich getrennten Stellen entlang der Antriebswelle statt. Da die Antriebswelle in ihrer Länge variabel ist, kann die Kraftübertragung vom Drehantrieb auf die Fördermechanismen auch bei einer größeren Distanz zwischen den Fördermechanismen auf konstruktiv einfache Weise erfolgen. Auf konstruktiv aufwendige und störungsanfällige Kraftübertragungsmechanismen zur Überbrückung der Distanz, wie beispielsweise Antriebsriemen, kann weitgehend verzichtet werden. Im Idealfall ist es möglich, die jeweiligen Enden der Antriebswelle unmittelbar, beispielsweise über ein einfaches Zahnradgetriebe, mit dem jeweiligen Fördermechanismus zu koppeln. Durch die Reduzierung der Bauteile ergibt sich für die Zuführvorrichtung eine kostengünstige und zuverlässige Konstruktion.

In einer Ausgestaltung der Zuführvorrichtung nach Anspruch 2 ist das erste Ende der Antriebswelle über eine erste Freilaufkupplung mit dem ersten Fördermechanismus gekoppelt und das zweite freie Ende über eine zweite Freilaufkupplung mit dem zweiten Fördermechanismus gekoppelt. Die Koppelung über die Freilaufkupplungen ist derart ausgebildet, dass bei Drehung der Antriebswelle in einer Drehrichtung der erste Fördermechanismus in der ersten Förderrichtung angetrieben wird und sich der zweite Fördermechanismus im Freilauf befindet, und, dass bei Drehung der Antriebswelle in einer entgegengesetzten Drehrichtung der zweite Fördermechanismus in der zweiten Förderrichtung angetrieben wird und sich der erste Fördermechanismus im Freilauf befindet. Bei dieser Ausgestaltung werden der erste Fördermechanismus und der zweite Fördermechanismus je nach Drehrichtung der Antriebswelle getrennt voneinander angetrieben. Die wechselseitige Ansteuerung der Fördermechanismen erfolgt durch einfache Umkehr der Drehrichtung des Drehantriebs, was den Steuerungsaufwand reduziert. Ein gleichzeitiges Fördern des Bauteilgurts mittels des ersten Fördermechanismus und der Abdeckfolie mittels des zweiten Fördermechanismus ist nicht möglich. Diese Ausgestaltung zeichnet sich durch niedrige Kosten, hohe Robustheit und Betriebssicherheit aus. Aufgrund des getrennten Betriebs der Fördermechanismen ist es nicht erforderlich, die Antriebsgeschwindigkeiten des ersten und zweiten Fördermechanismus mittels präziser Getriebe exakt aufeinander abzustimmen.

In einer weiteren Ausgestaltung der Zuführvorrichtung nach Anspruch 3 ist zumindest an dem ersten Fördermechanismus eine Bremseinrichtung vorgesehen, mittels der der erste Fördermechanismus abbremsbar ist, insbesondere wenn er sich im Freilauf befindet. Durch die Bremseinrichtungen wird erreicht, dass zumindest der erste Fördermechanismus sofort zum Stillstand kommt, sobald er sich im Freilauf befinden. Dadurch wird verhindert, dass der erste Fördermechanismus den Bauteilgurt durch den Schwung auch dann noch weiter transportiert, wenn er sich bereits im Freilauf befindet. Positionierungsfehler der Bauteile an der Entnahmeposition können so sicher vermieden werden.

Die Zuführvorrichtung kann gemäß Anspruch 4 auch dahingehend ausgestaltet werden, dass das erste freie Ende über ein erstes Getriebe mit dem ersten Fördermechanismus und das zweite freie Ende über ein zweites Getriebe mit dem zweiten Fördermechanismus gekoppelt sind, derart, dass bei Drehung der Antriebswelle der erste Fördermechanismus in der ersten Förderrichtung und der zweite Fördermechanismus in der zweiten Förderrichtung angetrieben werden. Das erste Getriebe und das zweite Getriebe sind dabei derart aufeinander abgestimmt, dass der erste Fördermechanismus den Bauteilgurt mit derselben Geschwindigkeit transportiert wie der zweite Fördermechanismus die Abdeckfolie. Diese Ausgestaltung ermöglicht einen synchronen Betrieb der beiden Fördermechanismen, d.h. einen zeitgleichen Transport des Bauteilgurts und der Abdeckfolie. Dies bedingt jedoch, dass das erste und das zweite Getriebe sehr präzise aufeinander abgestimmt sind. Bei dieser Ausgestaltung sind eine hohe Förderleistung und ein schnelles kontinuierliches Fördern der Bauteile möglich.

Eine weitere Ausgestaltung der Zuführvorrichtung gemäß Anspruch 5 umfasst einen dritten Fördermechanismus, mittels dem ein weiterer Bauteilgurt in der ersten Förderrichtung zu einer zweiten Entnahmeposition transportierbar ist, an der die Bauteile dem weiteren Bauteilgurt entnehmbar sind. Ferner weist die Zuführvorrichtung eine zweite Ablöseeinrichtung auf, mittels der eine weitere Abdeckfolie des weiteren Bauteilgurts vor der zweiten Entnahmeposition von einem Grundkörper des weiteren Bauteilgurts ablösbar ist. Mittels eines vierten Fördermechanismus der Zuführvorrichtung ist die abgelöste weitere Abdeckfolie in der zweiten Förderrichtung transportierbar. In dieser Ausgestaltung der Zuführvorrichtung ist das erste Ende der Antriebswelle über eine erste Freilaufkupplung mit dem ersten Fördermechanismus und das zweite freie Ende der Antriebswelle über eine zweite Freilaufkupplung mit dem zweiten Fördermechanismus gekoppelt. Ferner ist das erste Ende über eine dritte Freilaufkupplung mit dem dritten Fördermechanismus und das zweite freie Ende über eine vierte Freilaufkupplung mit dem vierten Fördermechanismus gekoppelt. Die Freilaufkupplungen sind derart ausgestaltet und angeordnet, dass bei Drehung der Antriebswelle in einer Drehrichtung der erste Fördermechanismus in der ersten Förderrichtung und der zweite Fördermechanismus in der zweiten Förderrichtung angetrieben werden, während sich der dritte Fördermechanismus und der vierte Fördermechanismus im Freilauf befinden. Bei einer Drehung der Antriebswelle in einer entgegengesetzten Drehrichtung werden der dritte Fördermechanismus in der ersten Förderrichtung und der vierte Fördermechanismus in der zweiten Förderrichtung angetrieben, während sich der erste und der zweite Fördermechanismus im Freilauf befinden. Bei dieser Ausgestaltung handelt es sich um eine zweispurige Zuführvorrichtung, mittels welcher zwei Bauteilgurte getrennt voneinander transportiert werden können. Je nach Drehrichtung der Antriebswelle wird jeweils auf einer Spur ein Bauteilgurt bzw. eine Abdeckfolie durch die entsprechenden Fördermechanismen transportiert, während sich die Fördermechanismen der jeweils anderen Spur im Freilauf befinden. Diese Zuführvorrichtung stellt eine sehr kostengünstige Variante für den Transport zweier Bauteilgurte mit nur einem Antrieb dar und eignet sich für Anwendungen, bei denen die beiden Bauteilgurte nicht gleichzeitig gefördert werden müssen.

In der Ausgestaltung der Zuführvorrichtung gemäß Anspruch 6, ist zumindest an dem ersten Fördermechanismus und an dem dritten Fördermechanismus jeweils eine Bremseinrichtung vorgesehen ist, mittels der der erste Fördermechanismus und der dritte Fördermechanismus abbremsbar sind. Bezüglich der Vorteile wird auf die Ausführung zu Anspruch 3 verwiesen.

Im Folgenden wird ein Ausführungsbeispiel der vorliegenden Erfindung mit Bezug auf die beigefügten Figuren näher erläutert. In den Figuren sind:
Figur 1 eine schematische Darstellung des Aufbaus einer Zuführvorrichtung;
Figur 2 eine schematische Darstellung eines Bauteilgurts,
Figur 3 ein schematische Darstellungen eines zweiten Ausführungsbeispiels der Zuführvorrichtung in der Draufsicht,
Figuren 4A und 4B jeweils schematische Darstellungen eines ersten Ausführungsbeispiels der Zuführvorrichtung in unterschiedlichen Betriebszuständen in einer Draufsicht;
Figuren 5A und 5B jeweils schematische Darstellungen eines dritten Ausführungsbeispiels der Zuführvorrichtung in unterschiedlichen Betriebszuständen in der Draufsicht

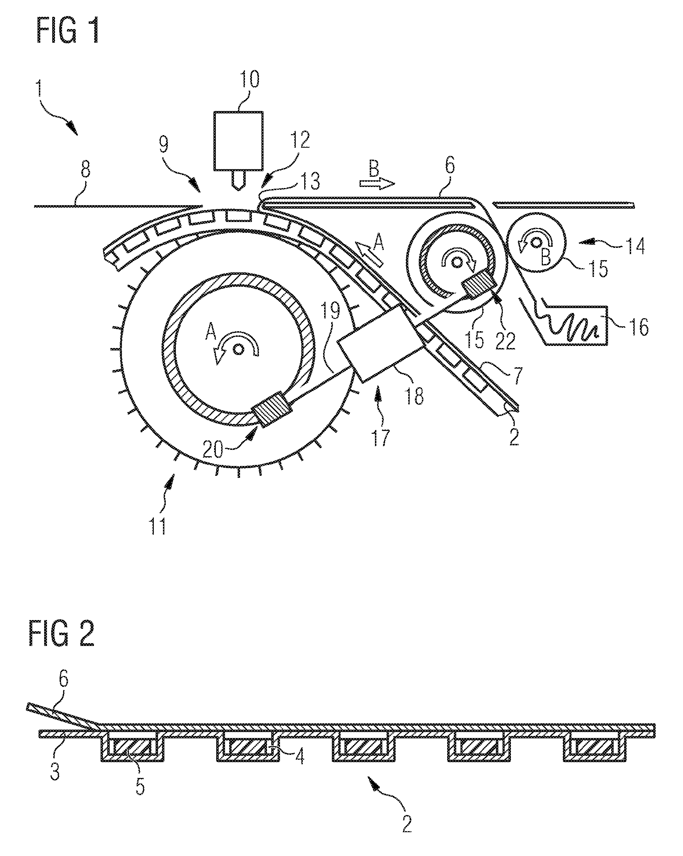

In Figur 1 ist eine Zuführvorrichtung 1 für in einem Bauteilgurt 2 gelagerte elektrische Bauteile schematisch dargestellt. Wie anhand Figur 2 deutlich wird, weist ein derartiger Bauteilgurt 2 einen Grundkörper 3 mit taschenartigen Vertiefungen 4 auf, in welchen die elektrischen Bauteile 5 gelagert sind. Um ein Herausfallen der Bauteile 5 zu verhindern, sind die taschenartigen Vertiefungen 4 mittels einer lösbaren Abdeckfolie 6 abgedeckt. Aus Figur 1 wird ersichtlich, dass der Bauteilgurt 2 in einem Förderkanal 7, welcher in einem Gehäuse 8 der Zuführvorrichtung 1 ausgebildet ist, geführt wird. Entlang des Förderkanals 7 befindet sich eine erste Entnahmeposition 9, an welcher die elektrischen Bauteile 5 aus den taschenartigen Vertiefungen 4 von Außen entnommen werden können. Dies kann beispielsweise durch einen Bestückkopf 10 eines Bestückautomaten (nicht dargestellt) geschehen.

Die Zuführvorrichtung 1 umfasst einen ersten Fördermechanismus 11, mittels welchem der Bauteilgurt 2 in einer ersten Förderrichtung (Pfeil A) zu der ersten Entnahmeposition 9 transportierbar ist. Im Ausführungsbeispiel handelt es sich bei dem ersten Fördermechanismus 11 um ein Transportrad 11 mit radial abstehenden Transportstiften, welche in Perforationen des Bauteilgurts 2 (nicht dargestellt) eingreifen, so dass der Bauteilgurt 2 bei Drehung des Transportrades 11 in der ersten Förderrichtung transportiert wird.

Die Zuführvorrichtung 1 umfasst ferner eine erste Ablöseeinrichtung 12, welche dazu dient, die Abdeckfolie 6 in der ersten Förderrichtung vor der ersten Entnahmeposition 9 vom Grundkörper 3 des Bauteilgurts 2 abzulösen. Dabei wird die Abdeckfolie 6 vor der ersten Entnahmeposition 9 über eine am Gehäuse 8 ausgebildete Abzugkante 13 geleitet und einem zweiten Fördermechanismus 14 zugeführt, welcher die abgelöste Abdeckfolie 6 in einer zweiten Förderrichtung (Pfeil B) transportiert. Der zweite Fördermechanismus 14 besteht aus zwei drehbaren Förderrädern 15, welche mittels eines Federelements (nicht dargestellt) an ihren Umfangsflächen gegeneinander gepresst sind. Die Abdeckfolie 6 wird zwischen den Umfangsflächen der Förderräder 15 geführt und bei Drehung der Förderräder 15 in der zweiten Förderrichtung einem Abfallbehälter 16 zugeführt.

Die Zuführvorrichtung 1 umfasst ferner einen Drehantrieb 17, welcher einen Elektromotor 18 und eine Antriebswelle 19 mit zwei freien Enden aufweist, wobei das erste Ende mit dem ersten Fördermechanismus 11 und das zweite freie Ende mit dem zweiten Fördermechanismus 14 gekoppelt ist. Die Koppelung kann jeweils durch ein entsprechend ausgebildetes Getriebe (Zahnradgetriebe, Schneckengetriebe oder Kegelradgetriebe) realisiert werden. Die freien Enden der Antriebswelle 19 liegen bezüglich dem Elektromotor 18 auf gegenüberliegenden Seiten.

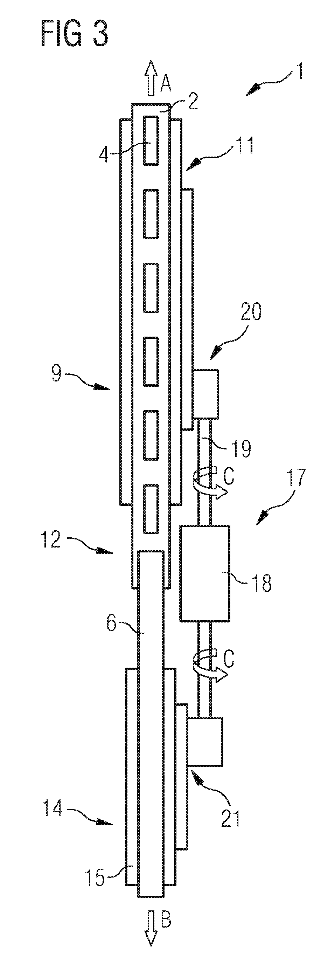

Figur 3 ist eine schematische Darstellung der in Figur 1 dargestellten Zuführvorrichtung 1 in der Draufsicht und zeigt ein erstes Ausführungsbeispiel der Zuführvorrichtung 1. In diesem ersten Ausführungsbeispiel ist der Drehantrieb 17 im Bereich des ersten freien Endes der Antriebswelle 19 über ein erstes Getriebe 20 mit dem ersten Fördermechanismus 11 bzw. dem Transportrad 11 unmittelbar verbunden. Im Bereich des zweiten freien Endes der Antriebswelle 19 ist der Drehantrieb 17 über ein zweites Getriebe 21 mit dem zweiten Fördermechanismus 14 bzw. einem der beiden Förderräder 15 unmittelbar verbunden. Die starre Koppelung der Antriebswelle 19 mit dem ersten und zweiten Fördermechanismus 11, 14 ist derart ausgestaltet, dass bei Drehung (Pfeil C) der Antriebswelle 19 bzw. bei Betrieb des Drehantriebs 17 das Transportrad 11 in der ersten Förderrichtung (Pfeil A) und die Förderräder 15 des zweiten Fördermechanismus 14 in der zweiten Förderrichtung (Pfeil B) angetrieben werden. Um einen störungsfreien Betrieb der Zuführvorrichtung 1 zu gewährleisten, sind das erste und zweite Getriebe 20, 21 derart aufeinander abgestimmt, dass der erste Fördermechanismus 11 den Bauteilgurt 2 und der zweite Fördermechanismus 14 die Abdeckfolie 6 mit derselben Geschwindigkeit transportieren.

Diese erste Ausführungsform der Zuführvorrichtung 1 ermöglicht einen zeitgleichen Transport des Bauteilgurts 2 und der Abdeckfolie 6 und somit eine kontinuierliche Bauteilezufuhr.

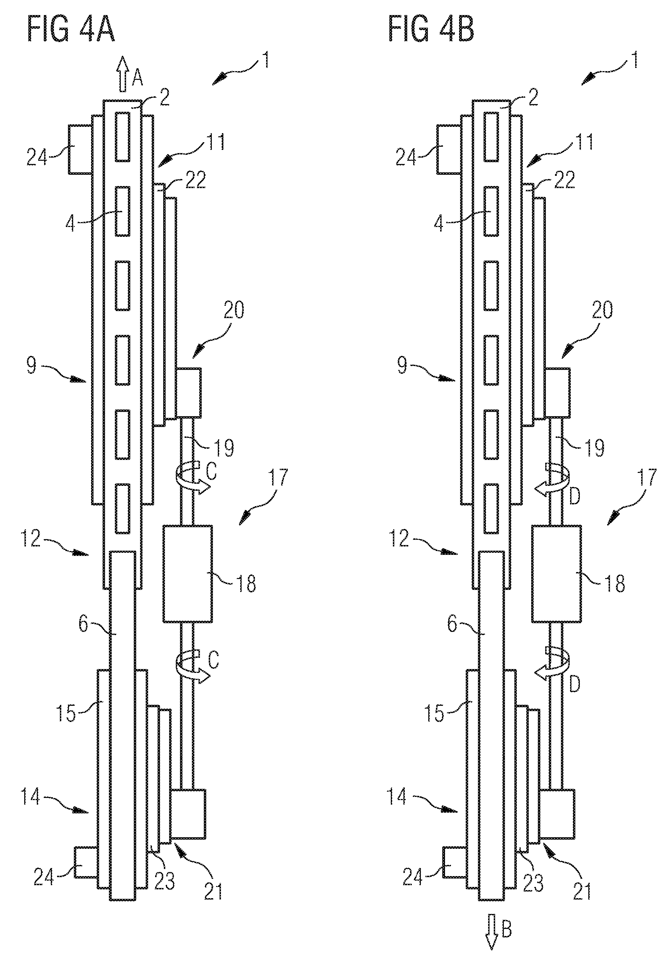

In den Figuren 4a und 4b ist ein zweites Ausführungsbeispiel der Zuführvorrichtung 1 beschrieben, dessen Aufbau im Wesentlichen dem der in Figur 1 dargestellten Zuführvorrichtung 1 entspricht. Jedoch ist der Drehantrieb 17 in diesem Ausführungsbeispiel auf Seiten des ersten Endes der Antriebswelle 19 über das erste Getriebe 20 und eine erste Freilaufkupplung 22 mit dem ersten Fördermechanismus 11 bzw. dem Transportrad 11 gekoppelt. Der Drehantrieb 17 ist ferner auf Seiten des zweiten freien Endes der Antriebswelle 19 über das zweite Getriebe 21 und eine zweite Freilaufkupplung 23 mit dem zweiten Fördermechanismus 14 bzw. einer der Förderräder 15 gekoppelt. Die erste und zweite Freilaufkupplung 22, 23 sind derart ausgebildet, dass nur in einer bestimmten Drehrichtung Kraftschluss zwischen dem Drehantrieb 17 und dem jeweiligen Fördermechanismus 11, 14 herrscht und in einer entgegengesetzten Drehrichtung die Fördermechanismen 22, 23 im Freilauf sind. Die erste Freilaufkupplung 22, das erste Getriebe 20, die zweite Freilaufkupplung 23 und das zweite Getriebe 21 sind ferner derart ausgebildet bzw. angeordnet, dass bei Drehung der Antriebswelle 19 in einer Drehrichtung (Pfeil C) der erste Fördermechanismus 11 in der ersten Förderrichtung (Pfeil A) angetrieben wird und sich der zweite Fördermechanismus 14 im Freilauf befindet (Figur 3A). Bei Drehung der Antriebswelle 19 in einer entgegengesetzten Drehrichtung (Pfeil D) wird der zweite Fördermechanismus 14 in der zweiten Förderrichtung (Pfeil B) angetrieben und der erste Fördermechanismus 11 befindet sich im Freilauf (Figur 3B).

An dem ersten Fördermechanismus 11 und am zweiten Fördermechanismus 14 ist jeweils eine Bremseinrichtung 24, beispielsweise ein pneumatisch betätigter Reibklotz, vorgesehen, welcher dazu dient, den zugehörigen Fördermechanismus 11, 14 abzubremsen, sobald sich dieser im Freilauf befindet. Dadurch wird verhindert, dass sich die Fördereinrichtungen 11, 14 durch den Schwung im Freilauf weiterdrehen.

Bei diesem zweiten Ausführungsbeispiel der Erfindung können das Transportrad 11 für den Bauteilgurt 2 und das Förderrad 15 für die Abdeckfolie 6 nur getrennt angetrieben werden. Dadurch ergibt sich der Vorteil, dass die beiden Getriebe 20, 21, über welche der erste Fördermechanismus 11 und der zweite Fördermechanismus 14 mit dem Drehantrieb 17 gekoppelt sind, nicht exakt aufeinander abgestimmt werden müssen, wodurch sich kostenmäßige Vorteile ergeben. Der wechselseitige Betrieb des ersten und zweiten Fördermechanismus 11, 14 geschieht daher durch entsprechende Steuerung der Drehrichtung des Drehantriebs 17, was den Steueraufwand stark reduziert.

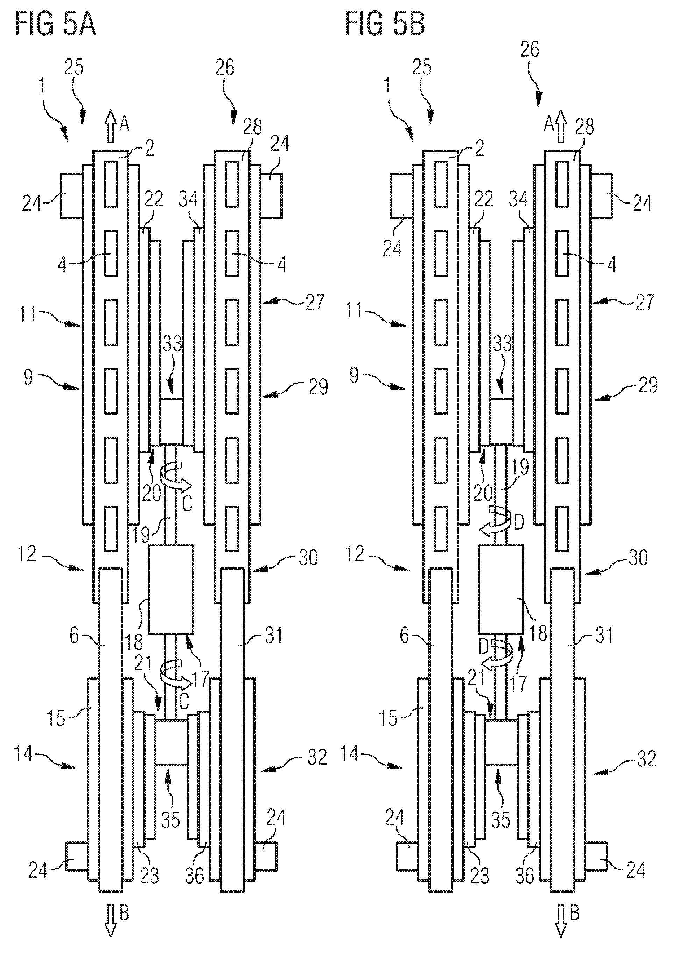

In den Figuren 5a und 5b ist ein drittes Ausführungsbeispiel der Zuführvorrichtung 1 in unterschiedlichen Betriebszuständen abgebildet. Diese Zuführvorrichtung 1 umfasst zwei parallele Transportspuren 25, 26 über welche zwei gleiche oder unterschiedliche Bauteilgurte 2, 28 gefördert werden können. Im Vergleich zum zweiten Ausführungsbeispiel gemäß den Figuren 4a und 4b sind die Fördermechanismen 11, 14 und die Ablöseeinrichtung 12, 30 doppelt vorgesehen und symmetrisch zum zentral angeordneten Drehantrieb 17 angeordnet. In der nachfolgenden Beschreibung wird angenommen, dass der prinzipielle Aufbau der jeweils linken Transportspur 25 und des Drehantriebs 17 dem Aufbau des zweiten Ausführungsbeispiels gemäß den Figuren 4A und 4B entspricht. Gleiche Elemente werden deshalb mit gleichen Bezugszeichen versehen.

Wie in den Figuren 5A und 5B jeweils auf der rechten Seite des Drehantriebs 17 dargestellt ist, umfasst die Zuführvorrichtung 1 gemäß dem dritten Ausführungsbeispiel einen dritten Fördermechanismus 27, mittels dem ein weiterer Bauteilgurt 28 in der ersten Förderrichtung (Pfeil A) zu einer zweiten Entnahmeposition 29 transportierbar ist, an der die Bauteile 5 dem weiteren Bauteilgurt 28 entnehmbar sind. Ferner ist eine zweite Ablöseeinrichtung 30 vorgesehen, mittels der eine weitere Abdeckfolie 31 des weiteren Bauteilgurts 28 in der ersten Förderrichtung vor der zweiten Entnahmeposition 29 von einem Grundkörper 3 des weiteren Bauteilgurts 28 ablösbar ist. Die Zuführvorrichtung 1 umfasst ferner einen vierten Fördermechanismus 32, mittels dem die abgelöste weitere Abdeckfolie 31 in der zweiten Förderrichtung (Pfeil B) transportierbar ist.

Analog zum zweiten Ausführungsbeispiel ist das erste Ende der Antriebswelle 19 des Drehantriebs 17 über ein erstes Getriebe 20 und eine erste Freilaufkupplung 22 mit dem ersten Fördermechanismus 11 und zugleich über ein drittes Getriebe 33 und eine dritte Freilaufkupplung 34 mit dem dritten Fördermechanismus 27 gekoppelt. Auf Seiten des zweiten freien Endes der Antriebswelle 19 ist der Drehantrieb 17 über das zweite Getriebe 21 und die zweite Freilaufkupplung 23 mit dem zweiten Fördermechanismus 14 und zugleich über ein viertes Getriebe 35 und eine vierte Freilaufkupplung 36 mit dem vierten Fördermechanismus 32 gekoppelt. Die Freilaufkupplungen 22, 23, 34, 36 sind dabei derart ausgebildet und angeordnet, dass bei Drehung der Antriebswelle 19 in einer Drehrichtung (Pfeil C) der erste Fördermechanismus 11 den ersten Bauteilgurt 2 in der ersten Förderrichtung (Pfeil A) und der zweite Fördermechanismus 14 die erste Abdeckfolie 6 in der zweiten Förderrichtung (Pfeil B) transportieren, während sich der dritte und der vierte Fördermechanismus 27, 32 im Freilauf befinden (siehe Figur 5A). Bei einer Drehung der Antriebswelle 19 in der entgegengesetzten Drehrichtung (Pfeil D) fördert der dritte Fördermechanismus 27 den weiteren Bauteilgurt 28 in der ersten Förderrichtung (Pfeil A) und der vierte Fördermechanismus 32 die weitere Abdeckfolie 31 in der zweiten Förderrichtung (Pfeil B), während sich der erste Fördermechanismus 11 und der zweite Fördermechanismus 14 im Freilauf befinden (siehe Figur 5B).
Auch im dritten Ausführungsbeispiel ist an dem ersten, zweiten, dritten und vierten Fördermechanismus 11, 14, 27, 32 jeweils eine Bremseinrichtung 24 vorgesehen, um den jeweiligen Fördermechanismus 11, 14, 27, 32 abzubremsen, insbesondere, wenn sich dieser im Freilauf befindet.

Aus der Beschreibung des dritten Ausführungsbeispiels wird deutlich, dass der erste Bauteilgurt 2 auf der ersten Transportspur 25 und der weitere Bauteilgurt 28 auf der zweiten Transportspur 26 in Abhängigkeit von der Drehrichtung des Drehantriebs getrennt voneinander gefördert werden können. Die Fördermechanismen auf Seiten der gleichen Transportspur 25, 26 werden dabei zeitgleich betrieben, so dass analog zum ersten Ausführungsbeispiel die jeweiligen Getriebe auf Seiten der gleichen Transportspur 25, 26 aufeinander abgestimmt sind. Der wechselseitige Transport des ersten und weiteren Bauteilgurts 2, 28 wird einfach durch die Drehrichtung des Drehantriebs gesteuert. Das dritte Ausführungsbeispiel der Zuführvorrichtung 1 stellt eine sehr kostengünstige Lösung mit zwei Transportspuren 25, 26 für zwei Bauteilgurte 2, 28 und nur einem Antrieb dar und ist für Anwendungen geeignet, bei denen die beiden Transportspuren 25, 26 nur getrennt zu betreiben sind.

Die Darstellung der obigen Ausführungsbeispiele zeigt, dass sich die erfindungsgemäßen Zuführvorrichtungen durch einen kostengünstigen, steuerungstechnisch und konstruktiv einfachen Aufbau auszeichnen. Dadurch, dass die Antriebswelle 19 zwei freie Enden aufweist, ist es möglich, örtlich weiter beabstandete Fördermechanismen 11, 14, 27, 32 für die Abdeckfolie 6 und den Bauteilgurt 2 mittels eines einzigen Drehantriebs 17 anzutreiben, wobei keine komplizierten Kraftübertragungsmechanismen, wie Antriebsriemen oder aufwendige Zahnradkonstruktionen, notwendig sind. Da nur ein Antrieb vorgesehen ist, ergeben sich nicht nur kostenmäßige, sondern auch bauraumtechnische Vorteile. Die steuerungstechnischen Vorteile ergeben sich dadurch, dass die Fördermechanismen 11, 14, 27, 32 lediglich durch Umkehr der Drehrichtung des Drehantriebs 17 wechselseitig angesteuert werden können.

## Patentansprüche

1. Zuführvorrichtung (1) für in einem Bauteilgurt (2) gelagerte elektrische Bauteile (5), wobei die Bauteile (5) in taschenartigen Vertiefungen (4) eines Grundkörpers (3) des Bauteilgurts (2) gelagert sind und mit einer lösbaren Abdeckfolie (6) abgedeckt sind, wobei die Zuführvorrichtung (1) aufweist:
- einen ersten Fördermechanismus (11), mittels dem der Bauteilgurt (2) in einer ersten Förderrichtung zu einer ersten Entnahmeposition (9) transportierbar ist, an der die Bauteile (5) dem Bauteilgurt (2) entnehmbar sind,
- eine erste Ablöseeinrichtung (12), mittels der die Abdeckfolie (6) vor der ersten Entnahmeposition (9) vom Grundkörper (3) des Bauteilgurts (2) ablösbar ist,
- einen zweiten Fördermechanismus (14), mittels dem die abgelöste Abdeckfolie (6) in einer zweiten Förderrichtung transportierbar ist,
- einen Drehantrieb (17), welcher eine Antriebswelle (19) mit zwei freien Enden aufweist, wobei das erste freie Ende mit dem ersten Fördermechanismus (11) gekoppelt ist und das zweite freie Ende mit dem zweiten Fördermechanismus (14) gekoppelt ist.

2. Zuführvorrichtung (1) nach Anspruch 1, wobei das erste Ende der Antriebswelle (19) über eine erste Freilaufkupplung (22) mit dem ersten Fördermechanismus (11) gekoppelt ist und das zweite freie Ende über eine zweite Freilaufkupplung (23) mit dem zweiten Fördermechanismus (14) gekoppelt ist, derart, dass bei Drehung der Antriebswelle (19) in eine Drehrichtung der erste Fördermechanismus (11) in der ersten Förderrichtung angetrieben wird und sich der zweite Fördermechanismus (14) im Freilauf befindet, und, dass bei Drehung der Antriebswelle (19) in einer entgegengesetzten Drehrichtung der zweite Fördermechanismus (14) in der zweiten Förderrichtung angetrieben wird und sich der erste Fördermechanismus (11) im Freilauf befindet.

3. Zuführvorrichtung (1) nach Anspruch 2, wobei zumindest an dem ersten Fördermechanismus (11) eine Bremseinrichtung (24) vorgesehen ist, mittels der der erste Fördermechanismus (11) abbremsbar ist.

4. Zuführvorrichtung (1) nach Anspruch 1, wobei das erste freie Ende über ein erstes Getriebe (20) mit dem ersten Fördermechanismus (11) und das zweite freie Ende über ein zweites Getriebe (21) mit dem zweiten Fördermechanismus (14) derart gekoppelt sind, dass bei Drehung der Antriebswelle (19) der erste Fördermechanismus (11) in der ersten Förderrichtung und der zweite Fördermechanismus (14) in der zweiten Förderrichtung angetrieben werden, und wobei das erste Getriebe (209) und das zweite Getriebe (21) derart aufeinander abgestimmt sind, dass der erste Fördermechanismus (11) den Bauteilgurt (2) und der zweite Fördermechanismus (14) die Abdeckfolie (6) mit derselben Geschwindigkeit transportieren.

5. Zuführvorrichtung (1) nach Anspruch 1, mit
- einem dritten Fördermechanismus (27), mittels dem ein weiterer Bauteilgurt (28) in der ersten Förderrichtung zu einer zweiten Entnahmeposition (29) transportierbar ist, an der die Bauteile (5) dem weiteren Bauteilgurt (28) entnehmbar sind,
- einer zweiten Ablöseeinrichtung (30), mittels der eine weitere Abdeckfolie (31) des weiteren Bauteilgurts (2) vor der zweiten Entnahmeposition (29) von einem Grundkörper (3) des weiteren Bauteilgurts (2) ablösbar ist,
- einem vierten Fördermechanismus (32), mittels dem die abgelöste weitere Abdeckfolie (31) in der zweiten Förderrichtung transportierbar ist,
wobei
das erste Ende der Antriebswelle (19) über eine erste Freilaufkupplung (22) mit dem ersten Fördermechanismus (11) und das zweite freie Ende über eine zweite Freilaufkupplung (23) mit dem zweiten Fördermechanismus (14) gekoppelt ist, und ferner das erste Ende der Antriebswelle (19) über eine dritte Freilaufkupplung (34) mit dem dritten Fördermechanismus (27) und das zweite freie Ende über eine vierte Freilaufkupplung (36) mit dem vierten Fördermechanismus (32) gekoppelt ist, derart, dass bei Drehung der Antriebswelle (19) in einer Drehrichtung der erste Fördermechanismus (11) in der ersten Förderrichtung und der zweite Fördermechanismus (14) in der zweiten Förderrichtung angetrieben werden und sich der dritte Fördermechanismus (27) und der vierte Fördermechanismus (32) im Freilauf befinden, und, dass bei Drehung der Antriebswelle (19) in einer entgegengesetzte Drehrichtung der dritte Fördermechanismus (27) in der ersten Förderrichtung und der vierte Fördermechanismus (32) in der zweiten Förderrichtung angetrieben werden und sich der erste Fördermechanismus (11) und der zweite Fördermechanismus (14) im Freilauf befinden.

6. Zuführvorrichtung nach Anspruch 5, wobei zumindest an dem ersten Fördermechanismus (11) und an dem dritten Fördermechanismus jeweils eine Bremseinrichtung (24) vorgesehen ist, mittels der der erste Fördermechanismus (11) und der dritte Fördermechanismus abbremsbar ist.
